# EUROPEAN PATENT APPLICATION

(11) **EP 4 810 989 A1**
(43) Date of publication of application: **23.09.2026**
(21) Application number: 26165561.7
(22) Date of filing: 17.03.2026
(51) Int. Cl.: G01S 7/481, G01S 17/86, H05K 1/02

(54) **DETECTION DEVICES**

(30) Priority: 17.03.2025 CN 202510322647
(71) Applicant: Suteng Innovation Technology Co., Ltd., Shenzhen, Guangdong 518000 (CN)
(72) Inventor: Yu, Zhiqiang, Shenzhen, 518000 (CN)
(74) Representative: RGTH

(57) **Abstract**

The first receiving lens is used to receive an echo light and output, so that the echo light is directed to the first receiving plate, and the echo light is formed by reflection of the detection laser from the target object; the camera module is mounted on the housing, and the camera module is used to acquire an image; the first predetermined direction is parallel to the optical axis of the transmitting lens. The detection device in this application makes the LiDAR function module and the vision function module integrated together, and the occupied space of the movable equipment can be relatively small, which is conducive to meeting the demand for miniaturisation of the movable equipment.

## Description

### Technical Fields

The present application relates to the field of detection technology, and in particular to a detection device.

### Background

Environment sensing is a key technology for mobile devices such as robots and vehicles with autonomous driving systems. Currently, there are two main approaches to achieve environmental sensing: the use of LiDAR and the use of vision devices. Since the two solutions have their own advantages and shortcomings, some mobile devices have adopted a fusion solution that integrates LiDAR and vision devices to achieve the complementary advantages of LiDAR and vision devices.

However, the current mobile devices using the fusion solution are difficult to miniaturise due to the simultaneous installation of LIDAR and vision devices, which take up more space in the mobile device.

### Specification

The present application provides a detection device designed to enable a fusion solution of LiDAR and vision devices and to facilitate the need for miniaturization of removable devices.

Embodiments of the present application propose a detection device, the detection device comprising:
a housing;
a transmitting module, mounted in the housing, comprising a transmitting plate and a transmitting lens spaced apart in a first predetermined direction, the transmitting plate being used for transmitting a detecting laser so as to cause the detecting laser to be projected outside of the detecting device through the transmitting lens for detecting a target object;
a receiving module, mounted in the housing, comprising a first receiving plate spaced apart along the first predetermined direction and a first receiving lens, the first receiving lens being used for receiving an echo light and outputting it so as to cause the echo light to be directed to the first receiving plate, wherein the echo light is formed by the reflection of the detecting laser by a target object;
a camera module, mounted in the housing, the camera module being used for acquiring images;
wherein the first predetermined direction is parallel to the optical axis of the transmitting lens.

The detection device in the embodiment of the present application has a transmitting module and a receiving module constituting a LiDAR function module, and a camera module can be used as a vision function module, thereby realising a fusion solution of the LiDAR function module and the vision function module. Furthermore, the detection device has a housing in which the transmitter module, the receiver module, and the camera module are mounted, so that the LIDAR function module and the vision function module are integrated, i.e., the detection device is an integrated device capable of realising the fusion solution. Compared with the technology in which the LIDAR and vision devices are installed independently of each other, the integrated device occupies a relatively small space on the movable equipment, which is conducive to meeting the demand for miniaturisation of the movable equipment. In addition, when the LIDAR and the vision device are distributed and installed in the movable device, it is necessary to calibrate both of them; in contrast, the detection device provided in the embodiments of the present application integrates the LIDAR function module and the vision function module together, so that the calibration process can be shifted to the calibration process of the detection device itself, and for the manufacturer of the movable device, there is no need to calibrate the LIDAR function module and the vision function module in addition. For manufacturers of mobile devices, there is no need to calibrate the LIDAR and vision modules separately, thus lowering the threshold of use for downstream manufacturers of mobile devices.

In some embodiments, the transmitting module is disposed between the receiving module and the camera module along a second predetermined direction, the second predetermined direction being perpendicular to the first predetermined direction.

So set up, on the one hand, so that the transmitter module and the receiver module adjacent to each other, so that the optical axis distance between the transmitter module and the receiver module can better meet the requirements of the setting of the LIDAR function module, and thus reduce the blind spot of the detection of the LIDAR function module. On the other hand, the transmitter module is located in the centre of the detection device, and the receiver module is located at the edge of the detection device, which makes it easier to build a heat dissipation path between the first receiver plate and the housing, because when the LIDAR function module is working, the heat generation of the first receiver plate is greater than that of the transmitter plate, therefore, it is easier to build a heat dissipation path between the first receiver plate and the housing. Therefore, the heat dissipation path between the first receiver plate and the housing can be constructed more easily, which is conducive to improving the comprehensive heat dissipation efficiency of the detection device.

In some embodiments, the detection device further comprises a main board, the main board being housed in the housing; the camera module comprising a second receiving plate and a second receiving lens spaced apart in the first predetermined direction; the main board being located on the side of the transmitting plate facing away from the transmitting lens in the first predetermined direction; the transmitting plate, the first receiving plate and the second receiving plate being located on the same side of the main board; the transmitting plate, the first receiving plate and the second receiving plate being electrically connected to the main board. the main board, the emitter board, the first receiving board and the second receiver board are electrically connected to the main board.

The transmitter board, the first receiving board, and the second receiver board are electrically connected to the main board, so that the main board can receive data from the LiDAR function module and data from the camera module, so that the data processing module on the main board can fuse the data from the LiDAR function module and the data from the camera module to obtain information such as the distance, shape, and type of the target object. In addition, the main board is set on the side of the transmitting board away from the transmitting lens, and the transmitting board, the first receiving board and the second receiving board are located on the same side of the main board, which is helpful to avoid the more complicated wiring when establishing the electrical connection relationship, and in addition, there is no need to set up the avoidance holes on the main board for the avoidance of the optical path, which is helpful to reduce the difficulty in the design of the main board.

The first receiver lens is mounted in the first receiver aperture; the second receiver plate is housed in the cavity and staggered from the transmitter plate in the first predetermined direction, the housing is provided with a second receiver aperture connected to the cavity, the second receiver lens is mounted in the second receiver aperture.

The transmitter plate, the first receiver plate, and the second receiver plate are all housed in the holding cavity, so that the housing protects the transmitter plate, the first receiver plate, and the second receiver plate.

In addition, the first receiving plate and the transmitting plate are staggered along the first predetermined direction, and the second receiving plate and the transmitting plate are staggered along the first predetermined direction, which is conducive to avoiding interference between the first receiving plate and the transmitting plate in a plane perpendicular to the first predetermined direction, and conducive to avoiding interference between the second receiving plate and the transmitting plate in a plane perpendicular to the first predetermined direction. In other words, if the first receiving plate, the second receiving plate and the transmitting plate are aligned along the first predetermined direction, then in order to avoid the above interference phenomenon, the spacing between the receiving module and the transmitting module needs to be set to be larger, and accordingly, the blind spot of the laser detection will be increased; the embodiment of the present application sets the transmitting plate in a staggered row with the first receiving plate and the second receiving plate, which is conducive to overcoming the above deficiencies. The embodiment of this application sets up the transmitter plate and the first receiver plate and the second receiver plate in a staggered manner to overcome the above shortcomings.

In some embodiments, the housing comprises a front housing and a rear housing, the front housing and the rear housing being spliced together in the first predetermined direction and together defining the holding cavity; the front housing being provided with the first transmitting through-hole, the first receiving through-hole, and the second receiving through-hole.

The shell comprises a front housing and a rear housing, and the front housing and the rear housing are constructed to accommodate a cavity by means of splicing, so that it is convenient to install the transmitting board, the first receiving board, the second receiving board, and the main board in the accommodating cavity. In addition, the transmitting lens, the first receiving lens, and the second receiving lens are mounted on the front housing through the first transmitting through-hole, the first receiving through-hole, and the second receiving through-hole, respectively, so that the transmitting lens, the first receiving lens, and the second receiving lens are fixedly connected to the shell to improve the positional stability of the respective lenses.

In some embodiments, the backshell is recessed at a position corresponding to the first receiving plate to form a countersink, and the first receiving plate is connected to the bottom wall of the countersink; the main board is provided with a notch at the countersink, and at least one side of the notch extends to the edge of the main board; the sidewall of the countersink is provided with an interface groove connecting to the holding cavity, and the detecting device further comprises a communication interface provided in the interface groove. a communication interface disposed in the interface slot.

The rear housing is concave at the position corresponding to the first receiver plate to form a sunken groove, and the first receiver plate is connected to the bottom wall of the sunken groove, so that the heat generated by the first receiver plate can be directly conducted to the rear housing to dissipate the heat through the rear housing, which makes the first receiver plate have a shorter heat dissipation path, and is conducive to the improvement of the overall heat dissipation efficiency of the detection device.

In addition, the side wall of the sink is provided with an interface slot connected to the holding cavity, and the communication interface of the detection device is provided in the interface slot, so that the communication interface is concealed on the back side of the detection device and close to the side side of the detection device, and thus structures such as the communication interface and the cable connected to the communication interface can be shielded and protected; furthermore, the concealed connection makes the product have a better aesthetic appearance.

In some embodiments, the detection device further comprises an inertial measurement unit, the inertial measurement unit being disposed on the main board, the transmitting module being at least partially coincident with the projection of the inertial measurement unit along the first predetermined direction.

The projection of the transmitting module and the inertial measurement unit along the first predetermined direction is at least partially coincident, and since the transmitting module is located approximately in the centre of the detection device, this facilitates the achievement of the purpose of placing the inertial measurement unit in the geometrical centre of the detection device or close to the geometrical centre of the detection device, and thus facilitates the reduction of the amount of data computation in order to increase the efficiency of the computation.

In some embodiments, the detection device further comprises a heat sink bracket, the heat sink bracket being secured to a side of the front housing facing the rear housing; at least one of the transmitting plate and the second receiving plate being connected to the heat sink bracket.

A heat dissipation bracket is fixed to the front case, and at least one of the transmitter board and the second receiver board is connected to the heat dissipation bracket, which allows heat generated during operation of the transmitter board and/or the second receiver board to be conducted through the heat dissipation bracket to the front case for heat dissipation.

In some embodiments, the housing further comprises a protective cover, the protective cover being disposed on a side of the front housing departing from the rear housing and being secured in a snap-fit with the front housing, the protective cover and the front housing defining a receptive cavity in which a portion of the transmitting lens, a portion of the first receiving lens and a portion of the second receiving lens are disposed.

The protective cover is connected to the front housing, the protective cover has a protective effect on the transmitting lens, the first receiving lens and the second receiving lens, in addition, the protective cover can also be used to cover the connecting structure between the lens and the front housing (for example, fasteners, seals), which is conducive to the protection of the lens as well as to enhance the reliability of the detection device, but also to enhance the aesthetics of the detection device.

In some embodiments, the transmitting board and the first receiving board are electrically connected via a flexible circuit board; the first receiving board is electrically connected to the main board via a board-to-board connector, and the second receiving board is electrically connected to the main board via a snap-on connector.

The transmitter board and the first receiving board are electrically connected through a flexible circuit board, which constitutes a two-connected board. On this basis, the first receiving board is electrically connected to the main board through a board-to-board connector, thus establishing an electrical connection between the transmitter board and the main board.

In addition, compared with the snap-on connectors, the board-to-board connectors have a higher data transmission efficiency, which can meet the data transmission requirements between the LiDAR function module and the main board, and at the same time, the snap-on connectors can also meet the transmission requirements between the camera module and the main board.

In some of these embodiments, the detection device further comprises a main board, the main board being housed in the housing, the main board being located on the side of the transmitting plate facing away from the transmitting lens in the first predetermined direction, the transmitting plate being located on the same side of the main board as the first receiving plate, the transmitting plate and the first receiving plate being electrically connected to the main board; the camera module comprising an image sensor and a second receiving lens, the image sensor being located on the main board, the second receiving lens being spaced apart from the image sensor in the first predetermined direction. the second receiving lens, the image sensor is disposed on the main board, the second receiving lens and the image sensor are spaced apart along the first predetermined direction.

In this setup, the main board can also receive data from the LiDAR function module, and the data processing module on the main board fuses the data from the LiDAR function module and the camera module to obtain information such as the distance, shape, and category of the target object. In addition, the main board is set on the side of the transmitting board away from the transmitting lens, and the transmitting board and the first receiving board are located on the same side of the main board, so that when establishing the electrical connection relationship, it is conducive to avoiding the more complicated wiring, and in addition, there is no need to set up the aperture on the main board for avoiding the optical path, which is conducive to reducing the difficulty of the design of the main board.

In some embodiments, the forward projection of the transmitting plate along the first predetermined direction and the forward projection of the first receiving plate in the first predetermined direction have an overlapping area. This results in a smaller spacing between the two to reduce the blind spot of the laser detection.

### The Accompanying Illustration

Figure 1 is a schematic diagram of the structure of a detection device provided in an embodiment of the present application; the
Figure 2 is an exploded schematic diagram of a detection device provided by an embodiment of the present application; the
Figure 3 is a top view schematic diagram of a detection device provided by an embodiment of the present application; the
FIG. 4 is a schematic diagram of a sectional view in the A-A direction of FIG. 5; the
Figure 5 is a schematic view of the structure of a detection device provided by an embodiment of the present application in another view; the
Figure 6 is a schematic diagram of the structure of a main board provided in an embodiment of the present application; the
Figure 7 is a schematic diagram of a connection of a transmitter board, a first receiving board, a second receiver board, and a main board provided in an embodiment of the present application.

### Attachment markings:

1. Detection devices; and
10, shell; 11, front housing; 111, first emitting hole; 112, first receiving through-hole; 113, second receiving through-hole; 12, rear housing; 121, countersink; 122, heat dissipation fins; 123, interface slot; 13, protective cover; 14, holding cavity; 15, sheltering cavity.
20, transmitting module; 21, transmitting board; 22, transmitting lens;
30, a receiving module; 31, a first receiving board; 32, a first receiving lens; the
40, a camera module; 41, a second receiving plate; 42, a second receiving lens; the
50, main board; 51, avoidance gap;
60, Heat dissipation bracket.
71, Flexible circuit boards; 72, Board-to-board connectors; 73, Snap-in connectors.

### Specific Implementations

In order to make the purpose, technical solutions and advantages of the present application clearer and more understandable, the present application is described in further detail in the following, taking into account the accompanying drawings and embodiments. It should be understood that the specific embodiments described herein are only for the purpose of explaining the present application, and are not intended to limit the present application.

In the description of the present application, it is to be understood that the terms "up", "down", "left", "right", etc., where they indicate an orientation or positional relationship based on that shown in the accompanying drawings, are intended only to facilitate the description of the application and to simplify the description, and do not indicate or imply that the device or element referred to must have an orientation or positional relationship. It is to be understood that if there are terms such as "up", "down", "left", "right", etc. which indicate an orientation or positional relationship based on the orientation or positional relationship shown in the accompanying drawings, it is only for the purpose of facilitating the description of the present application and simplifying the description, and is not to indicate or imply that the device or element referred to has to have a specific orientation, and be constructed and operated with a specific orientation, therefore, the terms describing the relationship of the positional relationship in the accompanying drawings are only used for the purpose of exemplary illustration, and are not to be construed as limitations on the present patent. Therefore, the terms used in the accompanying drawings to describe positional relationships are for illustrative purposes only and are not to be construed as limitations of this patent.

Furthermore, the terms "first" and "second" are used for descriptive purposes only and are not to be understood as implying or suggesting relative importance or implicitly specifying the number of technical features indicated. Thus, a feature defined with "first" or "second" may expressly or implicitly comprise one or more such features. In the description of the present application, "plurality" means at least two, e.g., two, three, etc., unless otherwise expressly and specifically limited.

In the description of this application, unless otherwise expressly provided and limited, the terms "mounting", "connection", "linking", "fixing", etc. are to be understood in a broad sense, e.g., as a fixed connection, as a detachable connection, or as a single unit; as a mechanical connection, as a mechanical connection, or as an integrated unit. The terms "mounted", "connected", "connected", "fixed", etc. are to be understood broadly, e.g., as a fixed connection, a removable connection, or an integral part; a mechanical connection, or an electrical connection; a direct connection, or an indirect connection through an intermediate medium; or a connection within the two elements or an interaction between the two elements, unless expressly limited otherwise. One of ordinary skill in the art will understand the specific meaning of the above terms in this application according to the specific circumstances.

Environment sensing is a key technology for mobile devices such as robots, vehicles with autonomous driving systems and drones. Currently, there are two main approaches to achieve environmental sensing: the use of LiDAR and the use of vision devices. Because of the respective advantages and shortcomings of the two solutions, some mobile devices have adopted a fusion solution that integrates LiDAR and vision devices to achieve the complementary advantages of LiDAR and vision devices.

However, the current mobile devices using the fusion solution are difficult to miniaturise due to the simultaneous installation of LIDAR and vision devices, which take up more space in the mobile device.

In order to solve the above problems, the embodiments of the present application propose a detection device, which is intended to be able to realise a fusion solution of LiDAR and vision devices, and is useful to meet the miniaturisation requirements of movable devices.

Among them, the movable equipment can be vehicles, drones, robots and other equipment, and when the movable equipment is a vehicle or a drone, it can further have an unmanned system.

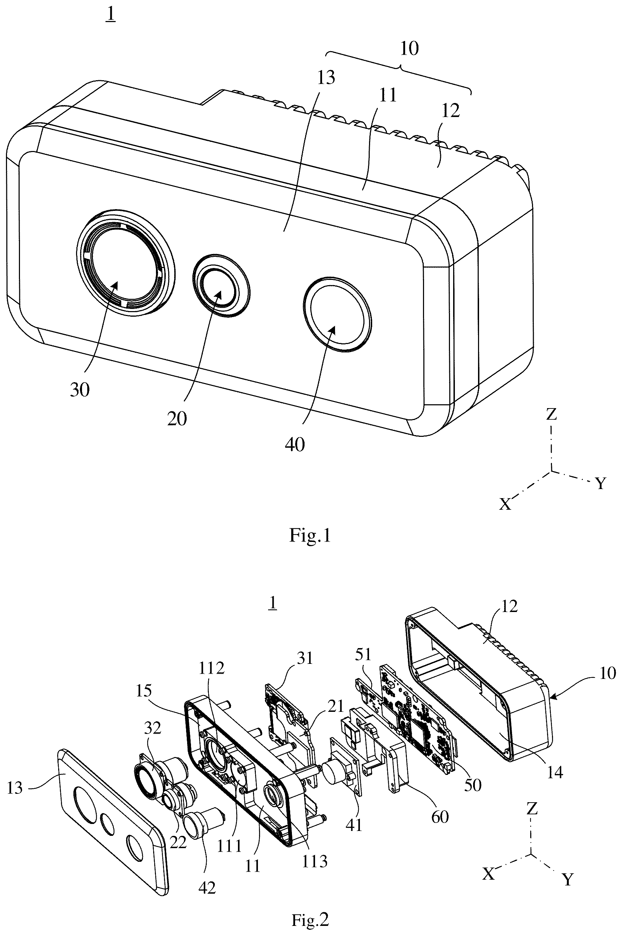

As shown in FIGS. 1, 2, 3, and 4, in one embodiment, the detection device 1 comprises a housing 10, a transmitting module 20, a receiving module 30, and a camera module 40. the transmitting module 20 is mounted to the housing 10, the transmitting module 20 comprises a transmitting plate 21 and a transmitting lens 22 spaced apart along a first predetermined direction X, the transmitting plate 21 being used to emit a detecting laser, so as to make the detecting laser emitted outside the detection device 1 via the transmitting lens 22 to detect a target object. The emitter plate 21 is used to emit a detection laser so that the detection laser is emitted to the outside of the detection device 1 through the emitter lens 22 to detect a target object. The receiving module 30 is mounted on the housing 10, and the receiving module 30 comprises a first receiving plate 31 and a first receiving lens 32 spaced along a first preset direction X. The first receiving lens 32 is used to receive the echo light and output the echo light to the first receiving plate 31, wherein the echo light is the detection laser light reflecting from the target object. The camera module 40 is installed in the housing 10, and the camera module 40 is used for acquiring images. The camera module 40 is used to acquire images, wherein a first predetermined direction X is parallel to the optical axis of the transmitting lens 22.

The detection device 1 comprises a transmitting module 20 and a receiving module 30, which may constitute a LiDAR function module. Among them, the transmitting board 21 may comprise a transmitting driver board and a laser disposed in the transmitting driver board, and the first receiving board 31 may comprise a receiving driver board and a photodetector disposed in the receiving driver board. When the detection device 1 is in operation, the transmitting plate 21 can transmit a detection laser, and the detection laser is emitted outside the detection device 1 through the transmitting lens 22 to detect a target object. The detection laser is reflected by the target object to form an echo light, and the first receiving lens 32 receives the echo light and causes the echo light to be emitted to the first receiving plate 31. As a result, a LIDAR function module can be formed by the transmitting module 20 and the receiving module 30 to realise environmental sensing.

The detection device 1 further comprises a camera module 40, the camera module 40 being used for acquiring an image, such that visual information can be provided by the camera module 40 for environmental sensing.

The detection device 1 in the embodiment of the present application, in which the transmitting module 20 and the receiving module 30 constitute a LiDAR function module, and the camera module 40 can be used as a vision function module, can thus realise a fusion solution of the LiDAR function module and the vision function module. Moreover, the detection device has a housing 10 in which the transmitter module 20, the receiver module 30, and the camera module 40 are mounted, so that the LIDAR function module and the vision function module are integrated, i.e., the detection device 1 becomes an integrated device capable of realising a fusion solution. Compared to the way in which the LIDAR and the vision device are independently installed in the related technology, the integrated device can take up a relatively small space on the movable device, which is conducive to meeting the demand for miniaturisation of the movable device. In addition, when the LIDAR and the vision device are distributed and installed in the movable device, it is necessary to calibrate both of them; in contrast, the detection device 1 provided in the embodiments of the present application integrates the LIDAR function module and the vision function module together, so that the calibration process can be shifted to the calibration process of the detection device itself, and for the manufacturer of the movable device, there is no need to calibrate the LIDAR function module and the vision function module in addition. For manufacturers of mobile devices, there is no need to calibrate the LIDAR function module and the vision function module separately, thus lowering the threshold for downstream manufacturers of mobile devices.

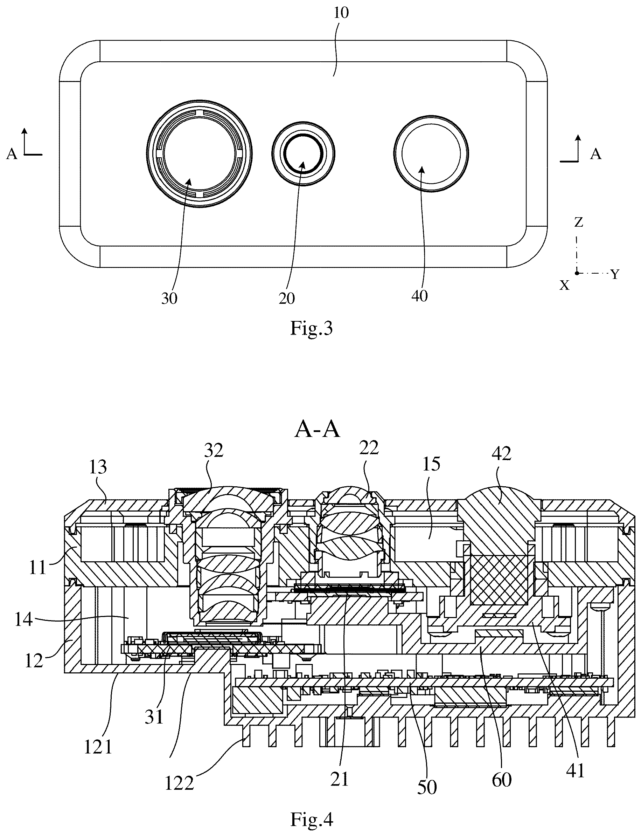

FIGS. 3 and 4 show that, in some embodiments, the transmitting module 20 is disposed between the receiving module 30 and the camera module 40 along the second predetermined direction Y. The second predetermined direction Y is perpendicular to the first predetermined direction X.

Such a setting, on the one hand, makes the transmitting module 20 and the receiving module 30 adjacent to each other, so that the optical axis distance between the transmitting module 20 and the receiving module 30 can better meet the requirements of the setting of the LIDAR function module, and thus reduce the detection blind spot of the LIDAR function module. On the other hand, the transmitting module 20 is located in the centre of the detection device 1, and the receiving module 30 is located at the edge of the detection device 1, which makes it easier to construct a heat dissipation path between the first receiving plate 31 and the housing 10, and the heat generation of the first receiving plate 31 is greater than that of the transmitting plate 21 when the LIDAR functional module is in operation, thus making it easier to construct a heat dissipation path between the first receiving plate 31 and the housing 10. As the heat generated by the first receiver plate 31 is greater than the heat generated by the transmitter plate 21 when the LiDAR function module is operating, the heat dissipation path between the first receiver plate 31 and the housing 10 can be constructed more easily, which is conducive to improving the comprehensive heat dissipation efficiency of the detection device 1.

As shown in FIGS. 2 and 4, in one embodiment, the camera module 40 comprises a second receiving plate 41 and a second receiving lens 42 spaced apart along a first predetermined direction X. The detection device 1 also comprises a main board 50, which is housed in the housing 10. Along the first predetermined direction X, the main board 50 is located on the side of the transmitting plate 21 away from the transmitting lens 22, the transmitting plate 21, the first receiving plate 31 and the second receiving plate 41 are located on the same side of the main board 50, and the transmitting plate 21, the first receiving plate 31 and the second receiving plate 41 are electrically connected to the main board 50.

The transmitter board 21, the first receiving board 31, and the second receiver board 41 are electrically connected to the main board 50, so that the main board 50 can receive data from the LIDAR function module and data from the camera module 40, so as to allow the data processing module on the main board 50 to fuse the data from the LIDAR function module and the data from the camera module 40, in order to obtain information such as the distance, the shape, and the category of the target object.

In addition, the main board 50 is set on the side of the transmitting board 21 away from the transmitting lens 22, and the transmitting board 21, the first receiving board 31 and the second receiving board 41 are located on the same side of the main board 50, so that when establishing the electrical connection relationship, it is helpful to avoid the more complicated way of routing, and in addition, there is no need to open the avoidance holes on the main board 50 for avoiding the optical path, so it is helpful to reduce the difficulty of the design of the main board 50.

In some other embodiments, the second receiving board 41 and the main board 50 may also be combined into the same board. Specifically, the detection device 1 further comprises a main board 50, the main board 50 is housed in the housing 10; along the first predetermined direction X, the main board 50 is located on the side of the transmitting board 21 facing away from the transmitting lens 22, the transmitting board 21 and the first receiving board 31 are located on the same side of the main board 50, and both the transmitting board 21 and the first receiving board 31 are electrically connected to the main board 50. The camera module 40 comprises an image sensor and a second receiving lens 42, the image sensor is disposed on the main board 50, and the second receiving lens 42 is disposed spaced apart from the image sensor along the first predetermined direction X. The camera module 40 comprises an image sensor and a second receiving lens 42.

In this setup, the main board 50 is also capable of receiving data from the LiDAR function module, and the data processing module on the main board 50 fuses the data from the LiDAR function module and the data from the camera module 40 to obtain information such as the distance, shape, and category of the target object. In addition, the main board 50 is set on the side of the transmitting board 21 away from the transmitting lens 22, and the transmitting board 21 and the first receiving board 31 are located on the same side of the main board 50; in this way, when establishing the electrical connection relationship, it is helpful to avoid the more complicated wiring, and in addition, there is no need to open the avoidance holes on the main board 50 for avoiding the optical path, which is helpful to reduce the difficulty of the design of the main board 50.

As shown in FIGS. 2 and 4, in one of the embodiments, the housing 10 is provided with a holding cavity 14, the launching plate 21 is housed in the holding cavity 14, the housing 10 is provided with a first launching aperture 111 connected to the holding cavity 14, and the launching lens 22 is mounted in the first launching aperture 111. Similarly, a first receiving plate 31 is housed in the holding cavity 14 and staggered from the launching plate 21 in a first preset direction X. A second receiving plate 41 is housed in the housing 10 with a first receiving aperture 112 connected to the holding cavity 14, and a first receiving lens 32 is mounted in the first receiving aperture 112. Similarly, the first receiving plate 31 is housed in the holding cavity 14 and is staggered from the transmitting plate 21 in the first predetermined direction X. The housing 10 is provided with a first receiving through-hole 112 connected to the holding cavity 14, and the first receiving lens 32 is mounted in the first receiving through-hole 112. The second receiving plate 41 is housed in the holding cavity 14 and is staggered from the transmitting plate 21 in the first predetermined direction X. The housing 10 is provided with a second receiving through-hole 113 connected to the holding cavity 14, and the second receiving lens 42 is mounted in the second receiving through-hole 113. 113.

The transmitter plate 21, the first receiver plate 31 and the second receiver plate 41 are all housed in the holding cavity 14, so that the housing 10 protects the transmitter plate 21, the first receiver plate 31 and the second receiver plate 41.

In addition, the first receiving plate 31 and the transmitting plate 21 are staggeredly disposed along the first predetermined direction X, and the second receiving plate 41 and the transmitting plate 21 are staggeredly disposed along the first predetermined direction X. This disposing is conducive to avoiding the first receiving plate 31 interfering with the transmitting plate 21 in a plane perpendicular to the first predetermined direction X, as well as being conducive to avoiding the second receiving plate 41 and the transmitting plate 21 in a plane perpendicular to the first predetermined direction X from X in the plane perpendicular to the first predetermined direction. In other words, if the first receiving plate 31, the second receiving plate 41 and the transmitting plate 21 are aligned along the first predetermined direction X, then in order to avoid the above interference phenomenon, the spacing between the receiving module 30 and the transmitting module 20 needs to be set to be larger, and accordingly, the blind spot of the laser detection will also increase; the embodiment of the application will stagger the setting of the transmitting plate 21 and the first receiving plate 31 and the second receiving plate 41 respectively. The embodiment of this application will transmit plate 21 and the first receiving plate 31 and the second receiving plate 41 respectively, the staggered way is conducive to overcome the above shortcomings. For example, the transmitting module 20 and the receiving module 30 can be configured so that the projection of the transmitting plate 21 along the first predetermined direction X and the projection of the first receiving plate 31 along the first predetermined direction X have an overlapping area, thus making the spacing between the two smaller, so as to reduce the blind spot of laser detection.

As shown in FIGS. 2 and 4, in one embodiment, the housing 10 comprises a front housing 11 and a rear housing 12, the front housing 11 and the rear housing 12 are spliced together along a first predetermined direction X and together define a holding cavity 14, and the front housing 11 is provided with a first transmitting through-hole 111, a first receiving through-hole 112, and a second receiving through-hole 113.

The housing 10 comprises a front housing 11 and a rear housing 12, and the front housing 11 and the rear housing 12 are constructed with a holding cavity 14 by means of a splicing connection, so that it is convenient to install the transmitting board 21, the first receiving board 31, the second receiving board 41, and the main board 50 in the holding cavity 14. In addition, the transmitting lens 22, the first receiving lens 32, and the second receiving lens 42 are mounted on the front case 11 through the first transmitting through-hole 111, the first receiving through-hole 112, and the second receiving through-hole 113, respectively, so that the transmitting lens 22, the first receiving lens 32, and the second receiving lens 42 are fixedly connected to the case 10 to improve the positional stability of the respective lenses.

It is understood that the transmitting board 21, the first receiving board 31, the second receiving board 41, and the main board 50 may be fixedly connected to the housing 10 directly or indirectly, respectively, in order to improve the positional stability of the respective boards, which may in turn ensure the working stability of the LiDAR function module and the camera module 40.

As shown in FIGS. 4, 5, and 6, in one of the embodiments, the rear housing 12 is recessed at a position corresponding to the first receiving plate 31 to form a countersink 121, the first receiving plate 31 is connected to the bottom wall of the countersink 121, the main board 50 is provided with a notch 51 at the countersink 121, and at least one side of the notch 51 extends to the edge of the main board 50, and an interface groove 123 is provided at a side wall of the countersink 121 that is connected to the holding cavity 14, and the detection device 1 also comprises a communication interface (not shown in the figures) provided at the interface groove 123. The detection device 1 further comprises a communication interface (not shown in the figure) provided in the interface slot 123.

Therein, the first receiving plate 31 and the bottom wall of the countersink 121 can be connected either by fasteners or by a thermally conductive adhesive, and in the latter case, the thermally conductive adhesive also fills the gap between the first receiving plate 31 and the bottom wall of the countersink 121, thereby obtaining a better thermal conductivity effect.

Compared to the transmitting board 21, the first receiving board 31 has to bear some additional computing work or data processing work, which makes the number of power devices on the first receiving board 31 more than that on the transmitting board 21, and therefore, when the LIDAR function module is in operation, the heat generation of the first receiving board 31 is greater than the heat generation of the transmitting board 21. In view of the above, in this embodiment, the rear housing 12 is concave at the position corresponding to the first receiver plate 31 to form a sink 121, the first receiver plate 31 is connected to the bottom wall of the sink 121, so that the heat generated by the first receiver plate 31 can be directly conducted to the rear housing 12 to dissipate heat through the rear housing 12, which allows the first receiver plate 31 to have a shorter heat dissipation path, conducive to the detection device 1 This makes the first receiving plate 31 have a shorter heat dissipation path, which is conducive to the improvement of the overall cooling efficiency of the detection device 1.

In addition, the side wall of the countersink 121 is provided with an interface slot 123 connected to the holding cavity 14, and the communication interface of the detection device 1 is provided in the interface slot 123, which makes the communication interface hidden on the back side of the detection device 1 and close to the side side of the detection device 1, and thus can form a shielding protection for the communication interface and the structure such as a cable connected to the communication interface; moreover, the hidden connection also makes the product have a better aesthetic appearance. The hidden connection also makes the product more aesthetically pleasing.

The main board 50 is provided with an avoidance notch 51 at the countersink 121, and the avoidance notch 51 is used to avoid the countersink 121 formed by the concavity of the backshell 12, so that the main board 50 matches the backshell 12 in shape to ensure that the main board 50 can be housed in the holding cavity 14. In addition, at least one side of the avoidance notch 51 extends to the edge of the main board 50, so that the at least one side of the avoidance notch 51 opens up, which is conducive to reducing the difficulty of machining, as well as to improving the production precision of the main board 50. In this way, it is favourable to reduce the processing difficulty of the notch 51 and to improve the production precision of the main board 50.

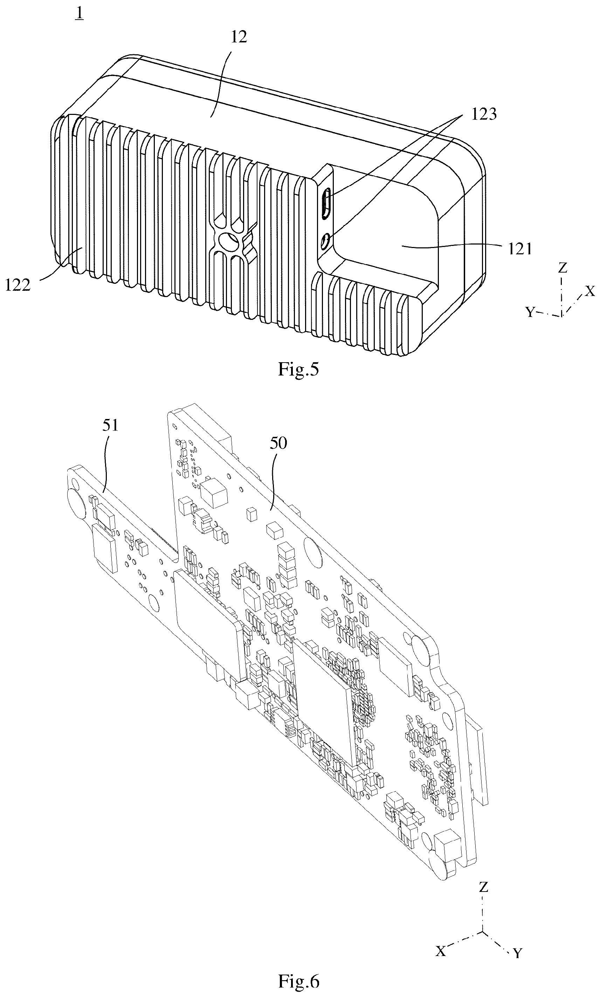

Further, as shown in FIG. 5, at least one side of the countersink 121 extends to the edge of the rear casing 12 so as to make the at least one side of the countersink 121 open, which is conducive to avoiding obstruction when plugging and unplugging the cables, and thus the operation of plugging and unplugging the data cables can be more convenient.

Further, as shown in FIG. 5, a plurality of cooling fins 122 are provided on the outer side of the rear housing 12. Since the main board 50 is mounted on the rear housing 12, and the heat generation of the main board 50 is large, the above rear housing 12 is provided with a plurality of cooling fins to increase the contact area between the outer surface of the rear housing 12 and the air, thereby improving the heat dissipation efficiency of the main board 50.

In one embodiment, the detection device 1 further comprises an inertial measurement unit (not shown in the figures), the inertial measurement unit being disposed on the main board 50, the transmitting module 20 being at least partially coincident with the projection of the inertial measurement unit along the first predetermined direction X. The inertial measurement unit is provided in the main board 50, the transmitting module 20 being at least partially coincident with the projection of the inertial measurement unit along the first predetermined direction X.

An Inertial Measurement Unit (IMU) is used to measure kinematic parameters (e.g., velocity, acceleration, etc.) of the linear motion of the probe 1 in three directions and kinematic parameters (e.g., angular velocity, angular acceleration, etc.) of the three basic angular motions.

When the inertial measurement unit is located at the geometric centre of the detection device 1, the IMU coordinate system coincides with the machine coordinate system of the detection device 1, which is conducive to the reduction of algorithm conversion steps. Therefore, it is possible to place the inertial measurement unit at the geometric centre of the detection device 1 as much as possible so that the IMU coordinate system and the machine coordinate system of the detection device 1 coincide completely. Alternatively, the inertial measurement unit can be placed close to the geometric centre of the detection device 1 so that the IMU coordinate system is partially coincident with the machine coordinate system of the detection device 1, in which case it is also beneficial to reduce the steps of algorithm conversion.

In this embodiment, the transmitting module 20 is at least partially coincident with the projection of the inertial measurement unit along the first predetermined direction X. Since the transmitting module 20 is located in a generally centred position of the detection device 1, it is advantageous to achieve the purpose of having the inertial measurement unit be at or close to the geometric centre of the detection device 1, and thus it is advantageous to reduce the amount of data computation in order to increase the efficiency of the computation.

As shown in FIGS. 2 and 4, in one embodiment, the detection device 1 further comprises a heat dissipation bracket 60, the heat dissipation bracket 60 being secured to a side of the front housing 11 facing the rear housing 12, and at least one of the transmitting plate 21 and the second receiving plate 41 being connected to the heat dissipation bracket 60.

Wherein at least one of the transmitting plate 21 and the second receiving plate 41 and the heat dissipation bracket 60 may be connected by fasteners or may be connected by a heat-conducting adhesive, and in the latter case, the heat-conducting adhesive may also fill in the gaps between the heat dissipation bracket 60 and the transmitting plate 21 and/or the second receiving plate 41 for obtaining a better heat-conducting effect.

The heat dissipation bracket 60 is fixed to the front case 11, and at least one of the transmitting plate 21 and the second receiving plate 41 is connected to the heat dissipation bracket 60, which allows the heat generated by the operation of the transmitting plate 21 and/or the second receiving plate 41 to be conducted to the front case 11 through the heat dissipation bracket 60 for heat dissipation.

It should be noted that the heat generation of the transmitting board 21 and the second receiving board 41 is smaller than the heat generation of the first receiving board 31, therefore, the heat of the transmitting board 21 and the second receiving board 41 is conducted to the shell 10 through the heat dissipation bracket 60, and although the heat dissipation path is enlarged, the actual heat dissipation efficiency can still satisfy the demand; moreover, there is no need to set up additional heat dissipation fins in the front housing 11.

In addition, the heat generated when the first receiving plate 31 is working can be directly conducted to the rear casing 12 for heat dissipation through the rear casing 12, and the heat generated when the transmitting plate 21 and/or the second receiving plate 41 is working is conducted to the front casing 11 for heat dissipation through the front casing 11, such an arrangement is conducive to enhancing the overall heat dissipation efficiency of the detection device 1.

It should be noted that the centred position of the transmitting module 20 and the edge position of the receiving module 30 of the detection device 1 are the result of a combination of factors such as heat dissipation efficiency and the amount of data computation after the introduction of the inertial measurement unit, as described below:
It is assumed that the transmitting module 20 and the receiving module 30 are interchanged, i.e., the receiving module 30 is set in a central position of the detecting device 1, and the transmitting module 20 is set in a side position of the detecting device 1. In this case, if the first receiving board 31 is connected to the heat dissipation bracket 60, the heat dissipation path of the first receiving board 31 will be longer, and among the transmitting board, the first receiving board 31, and the second receiving board 41, the first receiving board 31 generates the most heat, which causes the heat dissipation efficiency of the detecting device 1 to drop significantly.

Then, in order to solve the problem of heat dissipation efficiency, a possible way to shorten the heat dissipation path is to set up a countersink in the central position of the rear housing 12, so that the first receiving plate 31 is connected to the bottom wall of the countersink. However, in order to adapt to the position of the sink slot, it is necessary to open an avoidance slot in the position of the main board 50 corresponding to the first receiving plate 31, which in turn makes the inertial measurement unit only be far away from the geometric centre of the detection device 1, which leads to a larger amount of data computation of the detection device 1.

Therefore, in the embodiment of the present application, setting the transmitting module 20 in the centre position of the detection device 1 and the receiving module 30 in the side position of the detection device 1 is the best choice after considering various factors, which can reduce the data technology volume of the detection device 1 while obtaining a better heat dissipation efficiency, thereby improving the overall competitiveness of the product.

As shown in FIGS. 2 and 4, in one embodiment, the front housing 11 is provided with a first transmitting through-hole 111, a first receiving through-hole 112, and a second receiving through-hole 113 all passing through in a first predetermined direction X. The transmitting lens 22 is mounted in the first transmitting through-hole 111 of the front housing 11 and sealed by a sealing member (e.g., a sealing ring, a sealing adhesive), the first receiving lens 32 is mounted in the first receiving lens 32 is mounted in the first receiving through-hole 112 of the front housing 11, and is sealed by a sealing member (e.g., a sealing ring, a sealant); the second receiving lens 42 is mounted in the second receiving through-hole 113 of the front housing 11, and is sealed by a sealing member (e.g., a sealing ring, a sealant); thereby, the mounting of the transmitting lens 22, the first receiving lens 32, and the second receiving lens 42 to the housing 10 is possible. The housing 10 also comprises a protective cover 13, the protective cover 13 is disposed on the side of the front housing 11 away from the rear housing 12, and is fixed with the front housing 11, the protective cover 13 and the front housing 11 define a holding cavity 15, and a portion of the transmitting lens 22, a portion of the first receiving lens 32, and a portion of the second receiving lens 42 are disposed in the holding cavity 15. in some embodiments, the protective cover 13 can be used in the transmitting lens 22, the first receiving lens 32, and the second receiving lens 42, to achieve sealing. In some embodiments, the protective cover 13 can be provided with through holes in the above-mentioned transmitting lens 22, the first receiving lens 32, and the second receiving lens 42 to reveal the corresponding lenses, thereby enabling the lenses to achieve laser/visible light signals to send and receive; of course, in other embodiments, the protective cover 13 can be transparent, so that the lenses can also achieve laser/visible light signals to send and receive.

The protective cover 13 is connected to the front case 11, and the protective cover 13 protects the transmitting lens 22, the first receiving lens 32, and the second receiving lens 42, and the protective cover 13 can also be used to cover the connection structure (e.g., fasteners, seals) between the lenses and the front case 11, thereby protecting the lenses and enhancing the reliability of the detection device 1, and also contributing to the enhancement of the aesthetics of the detection device 1. The detection device 1 is also aesthetically pleasing.

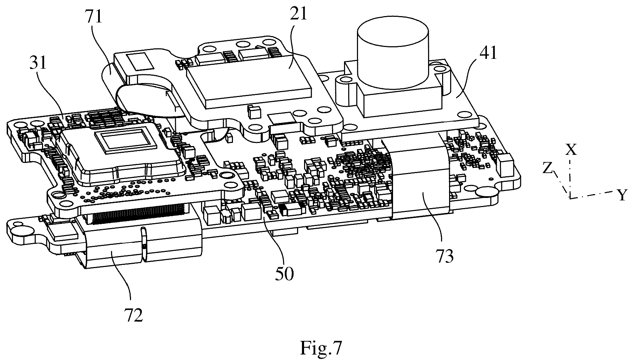

As shown in FIG. 7, in one embodiment, the transmitter board 21 and the first receiving board 31 are electrically connected via a flexible circuit board 71, the first receiving board 31 is electrically connected to the main board 50 via a board-to-board connector 72, and the second receiver board 41 is electrically connected to the main board 50 via a snap-on connector 73.

In this embodiment, the transmitting board 21 and the first receiving board 31 are electrically connected through the flexible circuit board 71, and the two constitute a two-connected board, based on which the first receiving board 31 is electrically connected to the main board 50 through the board-to-board connector 72, thereby enabling an electrical connection relationship to be established between the transmitting board 21 and the main board 50 as well.

In addition, compared to the snap-on connector 73, the board-to-board connector 72 has a higher data transmission efficiency, so that it can meet the data transmission needs between the LiDAR function module and the main board 50, and at the same time, the snap-on connector 73 is also able to meet the conveyance transmission needs between the camera module and the main board 50.

The above content is only a specific implementation of this application, but the scope of protection of this application is not limited to this, any skilled person familiar with the technical field in the scope of the technology disclosed in this application, can easily think of variations or substitutions, should be covered by the scope of protection of this application. Therefore, the scope of protection of this application shall be based on the scope of protection of the claims.

## Claims

1. A detection device, comprising:
a housing;
a transmitting module, mounted in the housing, comprising a transmitting plate and a transmitting lens spaced apart in a first predetermined direction, the transmitting plate being used for transmitting a detecting laser so as to cause the detecting laser to be projected outside of the detecting device through the transmitting lens for detecting a target object;
a receiving module, mounted in the housing, comprising a first receiving plate spaced apart along the first predetermined direction and a first receiving lens, the first receiving lens being used for receiving an echo light and outputting it so as to cause the echo light to be directed to the first receiving plate, wherein the echo light is formed by the reflection of the detecting laser by the target object;
a camera module, mounted in the housing, the camera module being used for acquiring images;
wherein the first predetermined direction is parallel to an optical axis of the transmitting lens.

2. The detection device according to claim 1, wherein along a second predetermined direction, the transmitting module is located between the receiving module and the camera module, the second predetermined direction being perpendicular to the first predetermined direction.

3. The detection device according to claim 2, the detection device further comprises a main board, the main board being housed in the housing;
the camera module comprising a second receiving plate and a second receiving lens spaced apart along the first predetermined direction;
along the first predetermined direction, the main board is located on a side of the transmitting board facing away from the transmitting lens, the transmitting board, the first receiving board and the second receiving board are located on the same side of the main board, and the transmitting board, the first receiving board and the second receiving board are electrically connected to the main board.

4. The detection device according to claim 3, wherein the housing is provided with a holding cavity, the transmitting plate is housed in the holding cavity, the housing is provided with a first transmitting through-hole connected to the holding cavity, and the transmitting lens is mounted in the first transmitting through-hole;
the first receiving plate is housed in the holding cavity and is staggered from the transmitting plate in the first predetermined direction, the housing is provided with a first receiving through-hole connected to the holding cavity, and the first receiving lens is mounted in the first receiving through-hole;
the second receiving plate is housed in the holding cavity and is staggered from the transmitting plate in the first predetermined direction, the housing is provided with a second receiving through-hole connected to the holding cavity, and the second receiving lens is mounted in the second receiving through-hole.

5. The detection device according to claim 4, wherein the housing comprises a front housing and a rear housing, the front housing and the rear housing being spliced together in the first predetermined direction and together defining the holding cavity;
the front housing is provided with a first transmitting through-hole, a first receiving through-hole, and a second receiving through-hole.

6. The detection device according to claim 5, wherein the rear housing is recessed at a position corresponding to the first receiving plate to form a countersink, the first receiving plate being connected to a bottom wall of the countersink;
the main board is provided with a notch in the countersink, at least a side of the notch extending to an edge of the main board,
a side wall of the countersink is provided with an interface slot connected to the holding cavity, the detection device further comprising a communication interface provided in the interface slot.

7. The detection device according to claim 6, wherein it further comprises an inertial measurement unit, the inertial measurement unit being disposed on the main board, the transmitting module being at least partially coincident with a projection of the inertial measurement unit along the first predetermined direction.

8. The detection device according to claim 5, further comprising:
a heat dissipation bracket, the heat dissipation bracket being fixed to a side of the front housing facing the rear housing;
wherein at least one of the transmitting plate and the second receiving plate is connected to the heat sink bracket.

9. The detection device according to claim 5, wherein the housing further comprises a protective cover, the protective cover being provided on a side of the front housing departing from the rear housing and being secured in a snap-fit with the front housing, the protective cover and the front housing defining a receiving cavity, a portion of the transmitting lens, a portion of the first receiving lens and a portion of the second receiving lens being located in the receiving cavity.

10. The detection device according to claim 3, wherein the transmitting board and the first receiving board are electrically connected by means of a flexible circuit board;
the first receiving board is electrically connected to the main board via a board-to-board connector, and the second receiver board is electrically connected to the main board via a snap-on connector.

11. The detection device according to claim 2, wherein the detection device further comprises a main board, the main board being housed in the housing, the main board being located on a side of the transmitting plate facing away from the transmitting lens along the first predetermined direction, the transmitting plate being located on the same side of the main board as the first receiving plate, the transmitting plate and the first receiving plate being electrically coupled to the main board;
the camera module comprises an image sensor and a second receiving lens, the image sensor being disposed on the main board, the second receiving lens and the image sensor being disposed at intervals along the first predetermined direction.

12. The detection device according to claim 1, wherein a positive projection of the transmitting plate along the first predetermined direction and a positive projection of the first receiving plate in the first predetermined direction have an overlapping region.
